# EUROPEAN PATENT APPLICATION

(11) **EP 4 740 769 A1**
(43) Date of publication of application: **13.05.2026**
(21) Application number: 24836229.5
(22) Date of filing: 17.06.2024
(51) Int. Cl.: A24F 40/50, A24F 40/57, A24F 40/465, H05B 6/36, G01R 23/15

(54) **METHOD FOR DETERMINING SUSCEPTOR CHANGE, AND AEROSOL GENERATING DEVICE FOR PERFORMING SAME METHOD**

(30) Priority: 05.07.2023 KR 20230087193; 25.08.2023 KR 20230112141
(71) Applicant: KT&G Corporation, Daedeok-gu Daejeon 34337 (KR)
(72) Inventor: LEE, Jaemin, Siheung-si Gyeonggi-do 15010 (KR); PARK, Sang Kyu, Seoul 05281 (KR)
(74) Representative: Ter Meer Steinmeister & Partner
(86) International application number: PCT/KR2024/008351
(87) International publication number: WO 2025/009780

(57) **Abstract**

A method for determining whether a susceptor is changed, according to one embodiment, may comprise the operations of: applying a first signal to a coil of a heater so as to generate an alternating magnetic field having a first frequency; determining a first value of an electrical characteristic of the susceptor indicated by the first signal; applying a second signal to the coil of the heater so as to generate an alternating magnetic field having a second frequency; determining a second value of an electrical characteristic of the susceptor indicated by the second signal; and determining whether the susceptor is a changed susceptor, on the basis of the first value and the second value.

## Description

### TECHNICAL FIELD

The following embodiments relate to a technology for controlling an aerosol generating device, and more particularly, to a technology for controlling an aerosol generating device that heats an aerosol generating article by using an induction heating scheme.

### BACKGROUND ART

The demand for electronic cigarettes has recently been on the rise. The rising demand for electronic cigarettes has accelerated the continued development of electronic cigarette-related functions. In particular, related functions are continuously being developed according to the type and characteristics of electronic cigarettes.

Typically, to heat a cigarette using an induction heating scheme, an electronic cigarette may use a coil to generate an alternating magnetic field to generate eddy currents in a susceptor adjacent to the cigarette. The temperature of the susceptor may increase due to the eddy currents generated in the susceptor.

### DISCLOSURE OF THE INVENTION

### TECHNICAL GOALS

An embodiment may provide an aerosol generating device that determines whether a susceptor is present in the aerosol generating device.

An embodiment may provide an aerosol generating device that determines whether a susceptor positioned within the aerosol generating device is a different susceptor than a previous susceptor.

### TECHNICAL SOLUTIONS

A method for determining a susceptor change, according to an embodiment, includes applying a first signal to a coil of a heater such that an alternating magnetic field having a first frequency is generated, determining a first value of an electrical characteristic of a susceptor indicated by the first signal, applying a second signal to the coil of the heater such that an alternating magnetic field having a second frequency is generated, determining a second value of an electrical characteristic of the susceptor indicated by the second signal, and determining whether the susceptor is a changed susceptor based on the first value and the second value.

An aerosol generating device, according to an embodiment, includes a coil configured to generate an alternating magnetic field, and a controller controlling the aerosol generating device, wherein the controller may be configured to apply a first signal to the coil such that an alternating magnetic field having a first frequency is generated, determine a first value of an electrical characteristic of a susceptor indicated by the first signal, apply a second signal to the coil such that an alternating magnetic field having a second frequency is generated, determine a second value of an electrical characteristic of the susceptor indicated by the second signal, and determine whether the susceptor is a changed susceptor based on the first value and the second value.

### EFFECTS OF THE INVENTION

According to at least one embodiment of the present disclosure, an aerosol generating device that determines whether a susceptor is present in the aerosol generating device and operates based on whether a susceptor is present may be provided.

According to at least one embodiment of the present disclosure, an aerosol generating device that determines a temperature of a susceptor based on electrical characteristics of a new susceptor when a susceptor in the aerosol generating device is a different susceptor than a previous susceptor may be provided.

### BRIEF DESCRIPTION OF DRAWINGS

FIGS. 1a to 1d are diagrams illustrating examples of an aerosol generating article inserted into an aerosol generating device, according to various embodiments.
FIGS. 2, 3 diagrams of examples of an aerosol generating article, of various embodiments.
FIG. 4 is a block diagram of an aerosol generating device, according to various embodiments.
FIG. 5 is a flowchart of a method of determining whether a susceptor is a changed susceptor, according to various embodiments.
FIG. 6 is a diagram illustrating trajectories of eddy currents in a susceptor indicated by frequencies of signals, according to various embodiments.
FIG. 7 is a diagram illustrating trajectories of impedance in a susceptor indicated by frequencies of signals, according to various embodiments.
FIG. 8 is a flowchart of a method of determining a temperature equation for a susceptor based on a first value and a second value of an electrical characteristic of the susceptor, according to various embodiments.
FIG. 9 is a flowchart of a method of controlling a temperature of a susceptor while an aerosol generating article is being heated, according to various embodiments.

### BEST MODE FOR CARRYING OUT THE INVENTION

The following detailed structural or functional description is provided as an example only and various alterations and modifications may be made to embodiments. Accordingly, the embodiments are not construed as limited to the disclosure and should be understood to include all changes, equivalents, and replacements within the idea and the technical scope of the disclosure.

Although terms of "first" or "second" are used to explain various components, the components are not limited to the terms. These terms should be used only to distinguish one component from another component. For example, a first component may be referred to as a second component, and similarly, the second component may also be referred to as the first component.

It will be understood that when a component is referred to as being "connected to" or "coupled" to another component, the component may be directly connected or coupled to the other component or intervening components may be present.

As used herein, the singular forms "a," "an," and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

Unless otherwise defined, all terms, including technical and scientific terms, used herein have the same meaning as commonly understood by one of ordinary skill in the art to which this disclosure pertains. Terms, such as those defined in commonly used dictionaries, are to be interpreted as having a meaning that is consistent with their meaning in the context of the relevant art, and are not to be interpreted in an idealized or overly formal sense unless expressly so defined herein.

Hereinafter, embodiments are described in detail with reference to the accompanying drawings. When describing the embodiments with reference to the accompanying drawings, like reference numerals refer to like elements and any repeated description related thereto will be omitted.

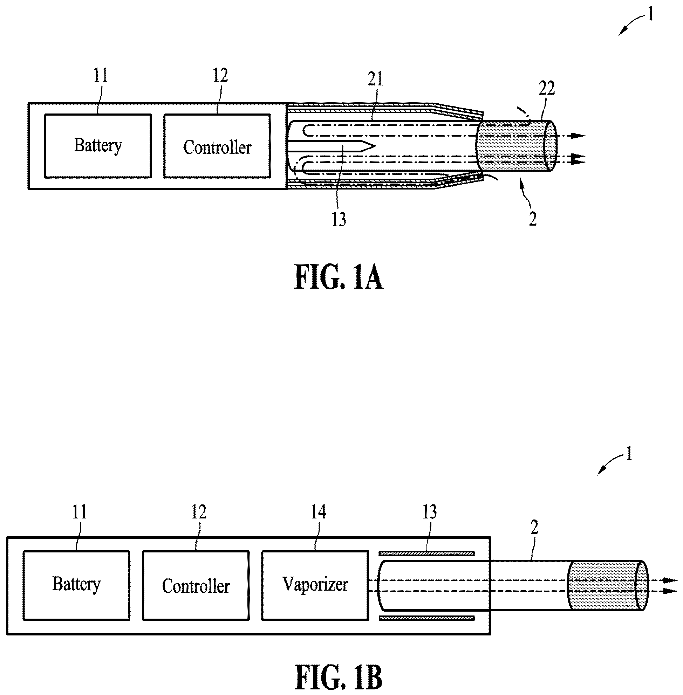

FIGS. 1a to 1d are diagrams illustrating examples of an aerosol generating article inserted into an aerosol generating device, according to various embodiments.

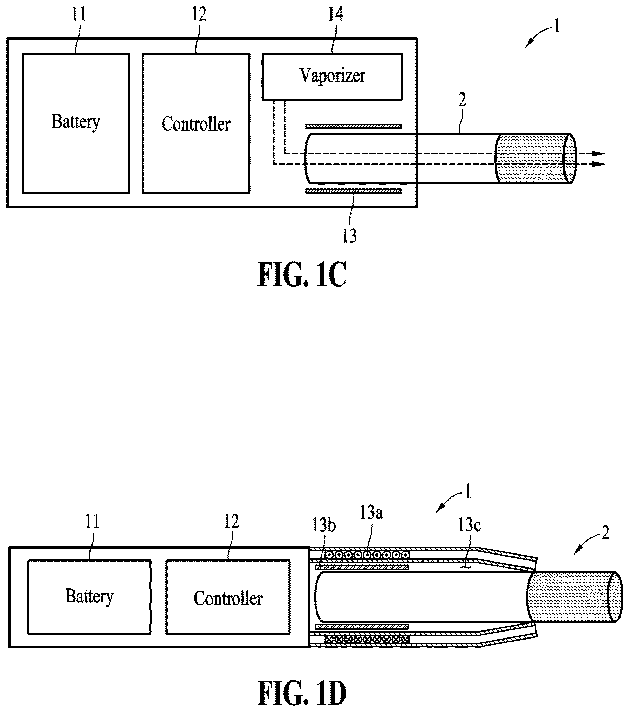

Referring to FIG. 1a, an aerosol generating device 1 includes a battery 11, a controller 12, and a heater 13. Referring to FIGS. 1b and 1c, the aerosol generating device 1 may further include a vaporizer 14. Referring to FIG. 1d, the aerosol generating device 1 includes the battery 11, the controller 12, a coil 13a, and a susceptor 13b. Further, a cigarette 2 may be inserted into an inner space of the aerosol generating device 1.

The aerosol generating device 1 shown in FIGS. 1a to 4 may include components related to the embodiments described herein. Therefore, it is to be understood by those having ordinary skill in the art to which the present disclosure pertains that the aerosol generating device 1 may further include other generally used components in addition to the ones shown in FIGS. 1a to 4.

In addition, although it is shown that the heater 13 is included in the aerosol generating device 1 in FIGS. 1b and 1c, the heater 13 may be omitted as necessary. For example, the aerosol generating device 1 that does not include the heater 13 may generate an aerosol through the vaporizer 14.

FIG. 1a illustrates a linear alignment of the battery 11, the controller 12, and the heater 13. In addition, FIG. 1b illustrates a linear alignment of the battery 11, the controller 12, the vaporizer 14, and the heater 13. In addition, FIG. 1c illustrates a parallel alignment of the vaporizer 14 and the heater 13. However, the internal structure of the aerosol generating device 1 is not limited to what is shown in FIGS. 1a to 1c. That is, such alignments of the battery 11, the controller 12, the heater 13, and the vaporizer 14 may be changed depending on the design of the aerosol generating device 1.

When the cigarette 2 is inserted into the aerosol generating device 1, the aerosol generating device 1 may actuate the heater 13 and/or the vaporizer 14 to generate an aerosol. The aerosol generated by the heater 13 and/or the vaporizer 14 may pass through the cigarette 2 into a user.

Even when the cigarette 2 is not inserted into the aerosol generating device 1, the aerosol generating device 1 may heat the heater 13, as necessary.

The battery 11 may supply power to be used to operate the aerosol generating device 1. For example, the battery 11 may supply power to heat the heater 13 or the vaporizer 14 and may supply power required for the controller 12 to operate. In addition, the battery 11 may supply power required to operate a display, a sensor, a motor, or the like installed in the aerosol generating device 1.

The controller 12 may control the overall operation of the aerosol generating device 1. For example, the controller 12 may control respective operations of other components included in the aerosol generating device 1 in addition to the battery 11, the heater 13, and the vaporizer 14. In addition, the controller 12 may verify a state of each of the components of the aerosol generating device 1 to determine whether the aerosol generating device 1 is in an operable state.

The controller 12 may include at least one processor. The processor may be implemented as an array of a plurality of logic gates or may be implemented as a combination of a general-purpose microprocessor and a memory in which a program executable by the microprocessor is stored. In addition, it is to be understood by one of ordinary skill in the art to which the present disclosure pertains that the processor may be implemented in other types of hardware.

The heater 13 may be heated by the power supplied by the battery 11. For example, when the cigarette 2 is inserted into the aerosol generating device 1, the heater 13 may be disposed outside the cigarette 2. The heated heater 13 may thus raise the temperature of an aerosol generating material in the cigarette 2.

The heater 13 may be an electrically resistive heater. For example, the heater 13 may include an electrically conductive track, and the heater 13 may be heated as a current flows through the electrically conductive track. However, the heater 13 is not limited to the above-described example, and any example of heating the heater 13 up to a desired temperature may be applicable without limitation. The desired temperature may be preset in the aerosol generating device 1 or may be set by the user.

Meanwhile, as another example, the heater 13 may be an induction heater including the coil 13a and the susceptor 13b as shown in FIG. 1d. Therefore, redundant descriptions of the heater 13 are omitted.

Specifically, the aerosol generating device 1 may include the electrically conductive coil 13a for heating the cigarette 2 in an induction heating manner and the susceptor 13b to be heated by the induction heater. Although not shown in FIG. 1d, the susceptor 13b may be included in the cigarette 2 rather than in the aerosol generating device 1.

For example, the heater 13 may include a tubular heating element, a plate-shaped heating element, a needle-shaped heating element, or a rod-shaped heating element and may heat the inside or outside of the cigarette 2 according to the shape of a heating element.

In addition, the heater 13 may be provided as a plurality of heaters in the aerosol generating device 1. In this case, the plurality of heaters 13 may be disposed to be inserted into the cigarette 2 or may be disposed outside the cigarette 2. In addition, some of the heaters 13 may be disposed to be inserted into the cigarette 2, and the rest may be disposed outside the cigarette 2. In addition, the shape of the heater 13 is not limited to the shape shown in FIGS. 1a to 1d and may be manufactured in various shapes.

The vaporizer 14 may heat a liquid composition to generate an aerosol, and the generated aerosol may pass through the cigarette 2 into the user. That is, the aerosol generated by the vaporizer 14 may travel along an airflow path of the aerosol generating device 1, and the airflow path may be configured such that the aerosol generated by the vaporizer 14 passes through the cigarette 2 into the user.

For example, the vaporizer 14 may include a liquid storage, a liquid transfer means, and a heating element. However, embodiments are not limited thereto. For example, the liquid storage, the liquid transfer means, and the heating element may be included as independent modules in the aerosol generating device 1.

The liquid storage may store the liquid composition. The liquid composition may be, for example, a liquid including a tobacco-containing material that includes a volatile tobacco flavor component or a liquid including a non-tobacco material. The liquid storage may be manufactured to be detachable and attachable from and to the vaporizer 14 or may be manufactured in an integral form with the vaporizer 14.

The liquid composition may include, for example, water, a solvent, ethanol, a plant extract, a fragrance, a flavoring agent, or a vitamin mixture. The fragrance may include, for example, menthol, peppermint, spearmint oil, various fruit-flavored ingredients, and the like. However, embodiments are not limited thereto. The flavoring agent may include ingredients that provide a user with a variety of flavors or scents. The vitamin mixture may be a mixture of at least one of vitamin A, vitamin B, vitamin C, or vitamin E, but is not limited thereto. The liquid composition may also include an aerosol former such as glycerin and propylene glycol.

The liquid transfer means may transfer the liquid composition in the liquid storage to the heating element. The liquid transfer means may be, for example, a wick such as cotton fiber, ceramic fiber, glass fiber, or porous ceramic. However, embodiments are not limited thereto.

The heating element may be an element configured to heat the liquid composition transferred by the liquid transfer means. The heating element may be, for example, a metal heating wire, a metal heating plate, a ceramic heater, or the like. However, embodiments are not limited thereto. In addition, the heating element may include a conductive filament such as a nichrome wire and may be arranged in a structure wound around the liquid transfer means. The heating element may be heated as a current is supplied and may transfer heat to the liquid composition in contact with the heating element, thereby heating the liquid composition. As a result, an aerosol may be generated.

For example, the vaporizer 14 may also be referred to as a cartomizer or an atomizer. However, embodiments are not limited thereto.

The aerosol generating device 1 may further include general-purpose components in addition to the battery 11, the controller 12, the heater 13, and the vaporizer 14. For example, the aerosol generating device 1 may include a display capable of outputting visual information and/or a motor for outputting tactile information. In addition, the aerosol generating device 1 may include at least one sensor (e.g., a puff sensor, a temperature sensor, a cigarette insertion detection sensor, etc.). In addition, the aerosol generating device 1 may be manufactured to have a structure in which external air may be introduced or internal gas may be discharged when the cigarette 2 is inserted into the aerosol generating device 1.

Although not shown in FIGS. 1a to 1d, the aerosol generating device 1 may also be configured as a system together with a separate cradle. For example, the cradle may be used to charge the battery 11 of the aerosol generating device 1. Alternatively, the cradle may be used to heat the heater 13 in a state in which the cradle and the aerosol generating device 1 are coupled.

Referring to FIG. 1d, the aerosol generating device 1 may include the battery 11, the controller 12, the coil 13a, the susceptor 13b, and a cavity 13c.

The cigarette 2 may be inserted into the cavity 13c of the aerosol generating device 1, and the coil 13a may be positioned around the cavity 13c. In FIG. 1d, the coil 13a is illustrated as being arranged to surround the cavity 13c. However, embodiments are not limited thereto.

The aerosol generating device 1 may generate an aerosol by heating the cigarette 2 using an induction heating scheme. The induction heating scheme may be a scheme of generating heat from a magnetic body by applying an alternating magnetic field.

When the alternating magnetic field is applied to the magnetic body, an energy loss due to an eddy current loss and a hysteresis loss may occur in the magnetic body. The lost energy may be released from the magnetic body as heat energy. As an amplitude or frequency of the alternating magnetic field increases, an amount of heat energy released from the magnetic body may increase. The magnetic body that generates heat due to an external magnetic field may be a susceptor.

The aerosol generating device 1 may include the susceptor 13b that generates heat by the external magnetic field. The aerosol generating device 1 may heat the cigarette 2 by applying an alternating magnetic field to the susceptor 13b.

The susceptor 13b may include metal or carbon. The susceptor 13b may include at least one of ferrite, a ferromagnetic alloy, stainless steel, or aluminum (Al).

Additionally, the susceptor 13b may include at least one of a ceramic such as graphite, molybdenum, silicon carbide, niobium, a nickel alloy, a metal film, zirconia, a transition metal such as nickel (Ni) or cobalt (Co), or a metalloid such as boron (B) or phosphorus (P).

The aerosol generating device 1 may include the cavity 13c for accommodating the cigarette 2. The cavity 13c may include an opening that opens on the outside of the cavity 13c to receive the cigarette 2 into the aerosol generating device 1.

The aerosol generating device 1 may include the coil 13a that applies an alternating magnetic field to the susceptor 13b. The coil 13a may be wound along a side of the cavity 13c. The coil 13a may be arranged near the susceptor 13b.

The coil 13a may receive power from the battery 10. As power is supplied to the coil 13a, a magnetic field may be formed inside the coil 13a. When an alternating current is applied to the coil 13a, the magnetic field formed inside the coil 13a may change direction periodically. When the susceptor 13b is exposed to the alternating magnetic field formed by the coil 13a, the susceptor 13b may generate heat, thereby heating the cigarette 2 accommodated in the aerosol generating device 1.

The temperature of the susceptor 13b that heats the cigarette 2 may change as an amplitude or frequency of the alternating magnetic field formed by the coil 13a changes. The controller 12 may control the power supplied to the coil 13a to adjust the amplitude or frequency of the alternating magnetic field formed by the coil 13a, and accordingly, the temperature of the susceptor 13b may be controlled.

As an example, the coil 13a may be implemented as a solenoid. The coil 13a may be a solenoid wound along the side of the cavity 13c. The cigarette 2 may be accommodated in an inner space of the solenoid. The solenoid may include, but is not limited to, copper (Cu).

To allow high current to flow by having low resistivity, the solenoid may include one or an alloy including at least one of silver (Ag), gold (Au), aluminum (Al), tungsten (W), zinc (Zn), and nickel (Ni).

The cigarette 2 may be similar to a general combustion type cigarette. For example, the cigarette 2 may be divided into a first portion including an aerosol generating material and a second portion including a filter or the like. Alternatively, the second portion of the cigarette 2 may also include an aerosol generating material. For example, an aerosol generating material provided in the form of granules or capsules may be inserted into the second portion.

The first portion may be entirely inserted into the aerosol generating device 1, and the second portion may be exposed outside. Alternatively, only the first portion may be partially inserted into the aerosol generating device 1, or the first portion may be entirely inserted into the aerosol generating device 1 and the second portion may be partially inserted into the aerosol generating device 1. The user may inhale the aerosol with the second portion in the user's mouth. In this case, the aerosol may be generated as external air passes through the first portion, and the generated aerosol may pass through the second portion into the user's mouth.

For example, the external air may be introduced through at least one air path formed in the aerosol generating device 1. For example, the opening and/or closing of the air path formed in the aerosol generating device 1 and/or the size of the air path may be adjusted by the user. Accordingly, an amount of atomization, a sense of smoking, or the like may be adjusted by the user. In another example, the external air may be introduced into the inside of the cigarette 2 through at least one hole formed on a surface of the cigarette 2.

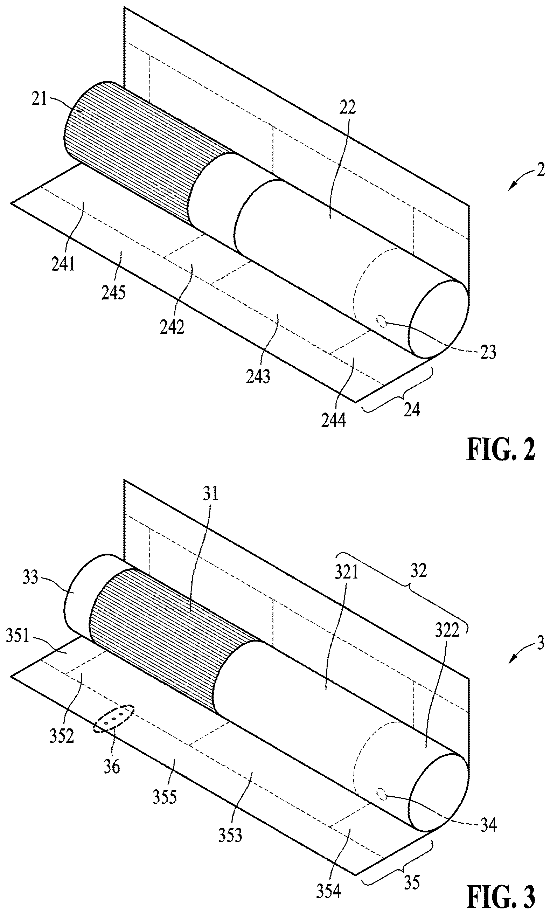

Hereinafter, examples of the cigarette 2 are described with reference to FIGS. 2 and 3.

FIGS. 2 and 3 are diagrams illustrating examples of a cigarette.

Referring to FIG. 2, the cigarette 2 includes a tobacco rod 21 and a filter rod 22. The first portion described above with reference to FIGS. 1a to 1d includes the tobacco rod 21, and the second portion includes the filter rod 22.

The filter rod 22 is illustrated as having a single segment in FIG. 2. However, embodiments are not limited thereto. That is, the filter rod 22 may include a plurality of segments. For example, the filter rod 22 may include a segment that cools an aerosol and a segment that filters a predetermined ingredient contained in an aerosol. In addition, the filter rod 22 may further include at least one segment that performs another function as necessary.

The diameter of the cigarette 2 may be in a range of 5 mm to 9 mm, and the length thereof may be about 48 mm. However, embodiments are not limited thereto. For example, the length of the tobacco rod 21 may be about 12 mm, the length of a first segment of the filter rod 22 may be about 10 mm, the length of a second segment of the filter rod 22 may be about 14 mm, and the length of a third segment of the filter rod 22 may be about 12 mm. However, embodiments are not limited thereto.

The cigarette 2 may be wrapped with at least one wrapper 24. The wrapper 24 may have at least one hole through which external air is introduced or internal gas flows out. In an example, the cigarette 2 may be wrapped with one wrapper 24. In another example, the cigarette 2 may be wrapped with two or more wrappers 24 in an overlapping manner. For example, the tobacco rod 21 may be wrapped with a first wrapper 241, and the filter rod 22 may be wrapped with wrappers 242, 243, and 244. In addition, the cigarette 2 may be entirely wrapped again with a fifth wrapper 245. For example, when the filter rod 22 includes a plurality of segments, the plurality of segments may be wrapped with the wrappers 242, 243, and 244, respectively.

The first wrapper 241 and the second wrapper 242 may be formed of general filter wrapping paper. For example, the first wrapper 241 and the second wrapper 242 may be porous wrapping paper or non-porous wrapping paper. In addition, the first wrapper 241 and the second wrapper 242 may be formed of oilproof paper and/or an aluminum laminated wrapping material.

The third wrapper 243 may be formed of hard wrapping paper. For example, a basis weight of the third wrapper 243 may be in a range of 88 g/m² to 96 g/m², and desirably, may be in a range of 90 g/m² to 94 g/m². Further, a thickness of the third wrapper 243 may be in a range of 120 *µ*m to 130 *µ*m, and desirably, may be 125 *µ*m.

The fourth wrapper 244 may be formed of oilproof hard wrapping paper. For example, a basis weight of the fourth wrapper 244 may be in a range of 88 g/m² to 96 g/m², and desirably, may be in a range of 90 g/m² to 94 g/m². Further, a thickness of the fourth wrapper 244 may be in a range of 120 *µ*m to 130 *µ*m, and desirably, may be 125 *µ*m.

The fifth wrapper 245 may be formed of sterile paper (e.g., MFW). Here, the sterile paper (MFW) may refer to paper specially prepared such that it has enhanced tensile strength, water resistance, smoothness, or the like, compared to general paper. For example, a basis weight of the fifth wrapper 245 may be in a range of 57 g/m² to 63 g/m², and desirably, may be 60 g/m². Further, a thickness of the fifth wrapper 245 may be in a range of 64 *µ*m to 70 *µ*m, and desirably, may be 67 *µ*m.

The fifth wrapper 245 may have a predetermined material internally added thereto. The predetermined material may be, for example, silicon. However, embodiments are not limited thereto. Silicon may have properties, such as, for example, heat resistance, which is characterized by less change by temperature, oxidation resistance which refers to resistance to oxidation, resistance to various chemicals, water repellency against water, or electrical insulation. However, silicon may not necessarily be used, and any material having such properties described above may be applied to (or used to coat) the fifth wrapper 245 without limitation.

The fifth wrapper 245 may prevent the cigarette 2 from burning. For example, there may be a probability that the cigarette 2 burns when the tobacco rod 21 is heated by the heater 13. For example, when the temperature rises above an ignition point of any one of materials included in the tobacco rod 21, the cigarette 2 may burn. Even in this example, it may still be possible to prevent the cigarette 2 from burning because the fifth wrapper 245 includes a non-combustible material.

In addition, the fifth wrapper 245 may prevent a holder from being contaminated by substances produced in the cigarette 2. For example, liquid substances may be produced in the cigarette 2 when a user puffs. For example, as an aerosol generated in the cigarette 2 is cooled by external air, liquid substances (e.g., water, etc.) may be produced. Thus, wrapping the cigarette 2 with the fifth wrapper 245 may prevent the liquid substances produced in the cigarette 2 from leaking out of the cigarette 2.

The tobacco rod 21 includes an aerosol generating material. The aerosol generating material may include, for example, at least one of glycerin, propylene glycol, ethylene glycol, dipropylene glycol, diethylene glycol, triethylene glycol, tetraethylene glycol, or oleyl alcohol. However, embodiments are not limited thereto. The tobacco rod 21 may also include other additives such as, for example, a flavoring agent, a wetting agent, and/or an organic acid. In addition, the tobacco rod 21 may include a flavoring liquid such as menthol or a moisturizing agent that is added as being sprayed onto the tobacco rod 21.

The tobacco rod 21 may be manufactured in various forms. For example, the tobacco rod 21 may be formed as a sheet or a strand. Alternatively, the tobacco rod 21 may be formed of tobacco leaves finely cut from a tobacco sheet. In addition, the tobacco rod 21 may be enveloped by a thermally conductive material. The thermally conductive material may be, for example, a metal foil such as aluminum foil. However, embodiments are not limited thereto. For example, the thermally conductive material enveloping the tobacco rod 21 may evenly distribute the heat transferred to the tobacco rod 21 to improve the conductivity of the heat to be applied to the tobacco rod 21, thereby improving the taste of tobacco. In addition, the thermally conductive material enveloping the tobacco rod 21 may function as a susceptor heated by an induction heater. Here, although not shown in the drawings, the tobacco rod 21 may further include an additional susceptor in addition to the thermally conductive material enveloping the outside thereof.

The filter rod 22 may be a cellulose acetate filter. However, a shape of the filter rod 22 is not limited. For example, the filter rod 22 may be a cylindrical rod, or a tubular rod including a hollow therein. The filter rod 22 may also be a recess-type rod. For example, when the filter rod 22 includes a plurality of segments, at least one of the segments may be manufactured in a different shape.

The first segment of the filter rod 22 may be a cellulose acetate filter. For example, the first segment may be a tubular structure including a hollow therein. The first segment may prevent internal materials of the tobacco rod 21 from being pushed back when the heater 13 is inserted and generate an aerosol cooling effect. A desirable diameter of the hollow included in the first segment may be adopted from a range of 2 mm to 4.5 mm. However, embodiments are not limited thereto.

A desirable length of the first segment may be adopted from a range of 4 mm to 30 mm. However, embodiments are not limited thereto. Desirably, the length of the first segment may be 10 mm. However, embodiments are not limited thereto.

The first segment may have a hardness that may be adjusted by adjusting content of a plasticizer in a process of manufacturing the first segment. In addition, the first segment may be manufactured by inserting a structure such as a film or a tube of the same or different materials therein (e.g., in the hollow).

The second segment of the filter rod 22 may cool an aerosol generated as the heater 13 heats the tobacco rod 21. The user may thus inhale the aerosol cooled down to a suitable temperature.

A length or diameter of the second segment may be determined in various ways according to the shape of the cigarette 2. For example, a desirable length of the second segment may be adopted from a range of 7 mm to 20 mm. Desirably, the length of the second segment may be about 14 mm. However, embodiments are not limited thereto.

The second segment may be manufactured by weaving a polymer fiber. In this case, a flavoring liquid may be applied to a fiber formed of a polymer. Alternatively, the second segment may be manufactured by weaving a separate fiber to which a flavoring liquid is applied and the fiber formed of the polymer together. Alternatively, the second segment may be formed with a crimped polymer sheet.

For example, the polymer may be prepared with a material selected from a group including polyethylene (PE), polypropylene (PP), polyvinyl chloride (PVC), polyethylene terephthalate (PET), polylactic acid (PLA), cellulose acetate (CA), and aluminum foil.

As the second segment is formed with the woven polymer fiber or the crimped polymer sheet, the second segment may include a single channel or a plurality of channels extending in a longitudinal direction. A channel used herein may refer to a path through which a gas (e.g., air or aerosol) passes.

For example, the second segment formed with the crimped polymer sheet may be formed of a material having a thickness between about 5 *µ*m and about 300 *µ*m, for example, between about 10 *µ*m and about 250 *µ*m. In addition, the total surface area of the second segment may be between about 300 mm²/mm and about 1000 mm²/mm. Further, an aerosol cooling element may be formed from a material having a specific surface area between about 10 mm²/mg and about 100 mm²/mg.

The second segment may include a thread containing a volatile flavor ingredient. The volatile flavor ingredient may be menthol, but is not limited thereto. For example, the thread may be filled with an amount of menthol sufficient to provide at least 1.5 mg of menthol to the second segment.

The third segment of the filter rod 22 may be a cellulose acetate filter. A desirable length of the third segment may be adopted from a range of 4 mm to 20 mm. For example, the length of the third segment may be about 12 mm. However, embodiments are not limited thereto.

The third segment may be manufactured such that a flavor is generated by spraying a flavoring liquid onto the third segment in the process of manufacturing the third segment. Alternatively, a separate fiber to which the flavoring liquid is applied may be inserted into the third segment. An aerosol generated in the tobacco rod 21 may be cooled as it passes through the second segment of the filter rod 22, and the cooled aerosol may pass through the third segment into a user. Accordingly, when a flavoring element is added to the third segment, the flavor carried to the user may last much longer.

**In** addition, the filter rod 22 may include at least one capsule 23. Here, the capsule 23 may perform a function of generating a flavor or a function of generating an aerosol. For example, the capsule 23 may have a structure in which a liquid containing a fragrance is wrapped with a film. The capsule 23 may have a spherical or cylindrical shape, but is not limited thereto.

Referring to FIG. 3, a cigarette 3 may further include a front end plug 33. The front end plug 33 may be disposed on one side of a tobacco rod 31 opposite to a filter rod 32. The front end plug 33 may prevent the tobacco rod 31 from escaping to the outside, and may also prevent an aerosol liquefied in the tobacco rod 31 during smoking from flowing into an aerosol generating device (e.g., the aerosol generating device 1 of FIGS. 1a to 1d).

The filter rod 32 may include a first segment 321 and a second segment 322. Here, the first segment 321 may correspond to the first segment of the filter rod 22 of FIG. 2, and the second segment 322 may correspond to the third segment of the filter rod 22 of FIG. 2.

A diameter and a total length of the cigarette 3 may correspond to the diameter and the total length of the cigarette 2 of FIG. 2. For example, a length of the front end plug 33 may be about 7 mm, a length of the tobacco rod 31 may be about 15 mm, a length of the first segment 321 may be about 12 mm, and a length of the second segment 322 may be about 14 mm. However, embodiments are not limited thereto.

The cigarette 3 may be wrapped with at least one wrapper 35. The wrapper 35 may have at least one hole through which external air is introduced or internal gas flows out. For example, the front end plug 33 may be wrapped with a first wrapper 351, the tobacco rod 31 may be wrapped with a second wrapper 352, the first segment 321 may be wrapped with a third wrapper 353, and the second segment 322 may be wrapped with a fourth wrapper 354. In addition, the cigarette 3 may be entirely wrapped again with a fifth wrapper 355.

In addition, at least one perforation 36 may be formed in the fifth wrapper 355. For example, the perforation 36 may be formed in an area surrounding the tobacco rod 31. However, embodiments are not limited thereto. The perforation 36 may perform a function of transferring heat generated by the heater 13 shown in FIGS. 1a to 1d to the inside of the tobacco rod 31.

In addition, the second segment 322 may include at least one capsule 34. The capsule 34 may perform a function of generating a flavor or a function of generating an aerosol. For example, the capsule 34 may have a structure in which a liquid containing a fragrance is wrapped with a film. The capsule 34 may have a spherical or cylindrical shape, but is not limited thereto.

The first wrapper 351 may be a combination of general filter wrapping paper and a metal foil such as aluminum foil. For example, a total thickness of the first wrapper 351 may be in a range of 45 *µ*m to 55 *µ*m, and desirably, may be 50.3 *µ*m. Further, a thickness of the metal foil of the first wrapper 351 may be in a range of 6 *µ*m to 7 *µ*m, and desirably, may be 6.3 *µ*m. In addition, a basis weight of the first wrapper 351 may be in a range of 50 g/m² to 55 g/m², and desirably, may be 53 g/m².

The second wrapper 352 and the third wrapper 353 may be formed with general filter wrapping paper. For example, the second wrapper 352 and the third wrapper 353 may be porous wrapping paper or non-porous wrapping paper.

For example, the porosity of the second wrapper 352 may be 35000 CU. However, embodiments are not limited thereto. Further, a thickness of the second wrapper 352 may be in a range of 70 *µ*m to 80 *µ*m, and desirably, may be 78 *µ*m. In addition, a basis weight of the second wrapper 352 may be in a range of 20 g/m² to 25g/m², and desirably, may be 23.5 g/m².

For example, the porosity of the third wrapper 353 may be 24000 CU. However, embodiments are not limited thereto. Further, a thickness of the third wrapper 353 may be in a range of 60 *µ*m to 70 *µ*m, and desirably, may be 68 *µ*m. In addition, a basis weight of the third wrapper 353 may be in a range of 20 g/m² to 25 g/m², and desirably, may be 21 g/m².

The fourth wrapper 354 may be formed with polylactic acid (PLA) laminated paper. Here, the PLA laminated paper may refer to three-ply paper including a paper layer, a PLA layer, and a paper layer. For example, a thickness of the fourth wrapper 354 may be in a range of 100 *µ*m to 120 *µ*m, and desirably, may be 110 *µ*m. In addition, a basis weight of the fourth wrapper 354 may be in a range of 80 g/m² to 100 g/m², and desirably, may be 88 g/m².

The fifth wrapper 355 may be formed of sterile paper (e.g., MFW). Here, the sterile paper (MFW) may refer to paper specially prepared such that it has enhanced tensile strength, water resistance, smoothness, or the like, compared to general paper. For example, a basis weight of the fifth wrapper 355 may be in a range of 57 g/m² to 63 g/m², and desirably, may be 60 g/m². Further, a thickness of the fifth wrapper 355 may be in a range of 64 *µ*m to 70 *µ*m, and desirably, may be 67 *µ*m.

The fifth wrapper 355 may have a predetermined material internally added thereto. The predetermined material may be, for example, silicon. However, embodiments are not limited thereto. Silicon may have properties, such as, for example, heat resistance, which is characterized by less change by temperature, oxidation resistance which refers to resistance to oxidation, resistance to various chemicals, water repellency against water, or electrical insulation. However, silicon may not necessarily be used, and any material having such properties described above may be applied to (or used to coat) the fifth wrapper 355 without limitation.

The front end plug 33 may be formed of cellulose acetate. For example, the front end plug 33 may be manufactured by adding a plasticizer (e.g., triacetin) to cellulose acetate tow. A mono denier of a filament of the cellulose acetate tow may be in a range of 1.0 to 10.0 and may desirably be in a range of 4.0 to 6.0. A mono denier of the filament of the front end plug 33 may be more desirably about 5.0. In addition, a cross section of the filament of the front end plug 33 may be Y-shaped. The total denier of the front end plug 33 may be in a range of 20000 to 30000, and may be desirably in a range of 25000 to 30000. The total denier of the front end plug 33 may be more desirably 28000.

In addition, as necessary, the front end plug 33 may include at least one channel, and a cross-sectional shape of the channel may be provided in various ways.

The tobacco rod 31 may correspond to the tobacco rod 21 described above with reference to FIG. 2. Thus, a further description of the tobacco rod 31 is omitted herein.

The first segment 321 may be formed of cellulose acetate. For example, the first segment may be a tubular structure including a hollow therein. The first segment 321 may be manufactured by adding a plasticizer (e.g., triacetin) to cellulose acetate tow. For example, a mono denier and a total denier of the first segment 321 may be the same as the mono denier and the total denier of the front end plug 33.

The second segment 322 may be formed of cellulose acetate. A mono denier of a filament of the second segment 322 may be in a range of 1.0 to 10.0, and desirably, may be in a range of 8.0 to 10.0. The mono denier of the filament of the second segment 322 may be more desirably 9.0. In addition, a cross section of the filament of the second segment 322 may be Y-shaped. A total denier of the second segment 322 may be in a range of 20000 to 30000, and desirably, may be 25000.

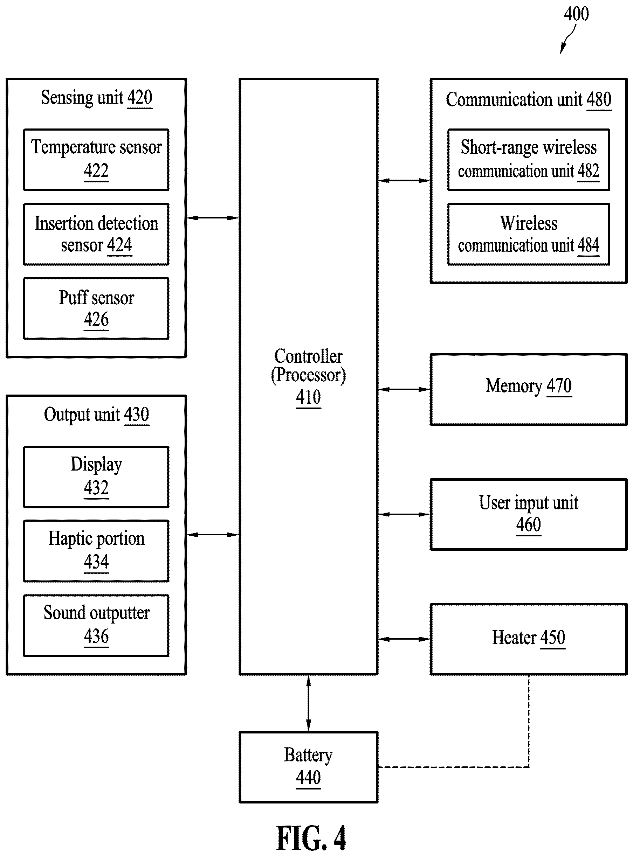

FIG. 4 is a block diagram of an aerosol generating device 400 according to another embodiment.

According to an embodiment, the aerosol generating device 400 (e.g., the aerosol generating device 1 of FIGS. 1a to 1d) may include a controller 410, a sensing unit 420, an output unit 430, a battery 440, a heater 450, a user input unit 460, a memory 470, and a communication unit 480. However, an internal structure of the aerosol generating device 400 is not limited to what is shown in FIG. 4. It is to be understood by those having ordinary skill in the art to which the disclosure pertains that some of the components shown in FIG. 4 may be omitted or new components may be added according to the design of the aerosol generating device 400.

The sensing unit 420 may sense a state of the aerosol generating device 400 or a state of an environment around the aerosol generating device 400 and transmit sensing information obtained through the sensing to the controller 410. Based on the sensing information, the controller 410 may control the aerosol generating device 400 to control operations of the heater 450, restrict smoking, determine whether an aerosol generating article (e.g., a cigarette, a cartridge, etc.) is inserted, display a notification, and perform other functions.

The sensing unit 420 may include at least one of a temperature sensor 422, an insertion detection sensor 424, or a puff sensor 426. However, embodiments are not limited thereto.

The temperature sensor 422 may sense a temperature at which the heater 450 (or an aerosol generating material) is heated. The aerosol generating device 400 may include a separate temperature sensor for sensing a temperature of the heater 450, or the heater 450 itself may perform a function as a temperature sensor. Alternatively, the temperature sensor 422 may be arranged around the battery 440 to monitor the temperature of the battery 440.

The insertion detection sensor 424 may sense whether the aerosol generating article is inserted and/or removed. The insertion detection sensor 424 may include, for example, at least one of a film sensor, a pressure sensor, a light sensor, a resistive sensor, a capacitive sensor, an inductive sensor, or an infrared sensor, which may sense a signal change by the insertion and/or removal of the aerosol generating article.

The puff sensor 426 may sense a puff from a user based on various physical changes in an airflow path or airflow channel. For example, the puff sensor 426 may sense the puff of the user based on any one of a temperature change, a flow change, a voltage change, and a pressure change.

The sensing unit 420 may further include at least one of a temperature/humidity sensor, an atmospheric pressure sensor, a magnetic sensor, an acceleration sensor, a gyroscope sensor, a position sensor (e.g., a global positioning system (GPS)), a proximity sensor, or a red, green, blue (RGB) sensor (e.g., an illuminance sensor), in addition to the sensors 422 through 426 described above. In addition, a function of each sensor may be intuitively inferable from its name by one of ordinary skill in the art, and thus, a detailed description thereof is omitted herein. For example, the sensing unit 420 may include a pressure sensor. The pressure sensor may be disposed adjacent to a space where a cigarette (e.g., the cigarette 2 of FIG. 2 or the cigarette 3 of FIG. 3) is inserted into the aerosol generating device 400, and may detect changes in airflow in the space. For example, the pressure sensor may detect negative pressure and/or positive pressure existing in a space where the pressure sensor is disposed. The pressure sensor may include at least a portion of the puff sensor 426 or the atmospheric pressure sensor.

The output unit 430 may output information about the state of the aerosol generating device 400 and provide the information to the user. The output unit 430 may include at least one of a display 432, a haptic portion 434, or a sound outputter 436. However, embodiments are not limited thereto. When the display 432 and a touchpad are provided in a layered structure to form a touchscreen, the display 432 may be used as an input device in addition to an output device.

The display 432 may visually provide the information about the aerosol generating device 400 to the user. The information about the aerosol generating device 400 may include, for example, a charging/discharging state of the battery 440 of the aerosol generating device 400, a preheating state of the heater 450, an insertion/removal state of the aerosol generating article, a limited usage state (e.g., an abnormal article detected) of the aerosol generating device 400, or the like, and the display 432 may externally output the information. The display 432 may be, for example, a liquid-crystal display panel (LCD), an organic light-emitting display panel (OLED), or the like. The display 432 may also be in the form of a light-emitting diode (LED) device.

The haptic portion 434 may provide the information about the aerosol generating device 400 to the user in a haptic manner by converting an electrical signal into a mechanical stimulus or an electrical stimulus. The haptic portion 434 may include, for example, a motor, a piezoelectric element, or an electrical stimulation device.

The sound outputter 436 may provide the information about the aerosol generating device 400 to the user in an auditory manner. For example, the sound outputter 436 may convert an electrical signal into a sound signal and externally output the sound signal.

The battery 440 may supply power to be used to operate the aerosol generating device 400. The battery 440 may supply power to heat the heater 450. In addition, the battery 440 may supply power required for operations of the other components (e.g., the sensing unit 420, the output unit 430, the user input unit 460, the memory 470, and the communication unit 480) included in the aerosol generating device 400. The battery 440 may be a rechargeable battery or a disposable battery. The battery 440 may be, for example, a lithium polymer (LiPoly) battery. However, embodiments are not limited thereto.

The heater 450 may receive power from the battery 440 to heat the aerosol generating material. Although not shown in FIG. 4, the aerosol generating device 400 may further include a power conversion circuit (e.g., a direct current (DC)-to-DC (DC/DC) converter) that converts power of the battery 440 and supplies the power to the heater 450. In addition, when the aerosol generating device 400 generates an aerosol in an induction heating manner, the aerosol generating device 400 may further include a DC-to-alternating current (AC) (DC/AC) converter that converts DC power of the battery 440 into AC power.

The controller 410, the sensing unit 420, the output unit 430, the user input unit 460, the memory 470, and the communication unit 480 may receive power from the battery 440 to perform functions. Although not shown in FIG. 4, the aerosol generating device 400 may further include a power conversion circuit, for example, a low dropout (LDO) circuit or a voltage regulator circuit, which converts power of the battery 440 and supplies the power to respective components.

In an embodiment, the heater 450 may be formed of any suitable electrically resistive material. The electrically resistive material may be a metal or a metal alloy including, for example, titanium, zirconium, tantalum, platinum, nickel, cobalt, chromium, hafnium, niobium, molybdenum, tungsten, tin, gallium, manganese, iron, copper, stainless steel, nichrome, or the like. However, embodiments are not limited thereto. In addition, the heater 450 may be implemented as a metal heating wire, a metal heating plate on which an electrically conductive track is arranged, a ceramic heating element, or the like. However, embodiments are not limited thereto.

In another embodiment, the heater 450 may be an induction heater. For example, the heater 450 may include a susceptor that heats the aerosol generating material by generating heat through a magnetic field applied by a coil.

In an embodiment, the heater 450 may include a plurality of heaters. For example, the heater 450 may include a first heater for heating a cigarette and a second heater for heating a liquid.

The user input unit 460 may receive information input from the user or may output information to the user. For example, the user input unit 460 may include a keypad, a dome switch, a touchpad (e.g., a contact capacitive type, a pressure resistive film type, an infrared sensing type, a surface ultrasonic conduction type, an integral tension measurement type, a piezo effect method, etc.), a jog wheel, a jog switch, or the like. However, embodiments are not limited thereto. In addition, although not shown in FIG. 4, the aerosol generating device 400 may further include a connection interface, such as a universal serial bus (USB) interface, and may be connected to another external device through the connection interface, such as a USB interface, to transmit and receive information or to charge the battery 440.

The memory 470, which is hardware for storing various pieces of data processed in the aerosol generating device 400, may store data processed by the controller 410 and data to be processed thereby. The memory 470 may include at least one type of storage medium of a flash memory type memory, a hard disk type memory, a multimedia card micro type memory, a card type memory (e.g., an SD or XE memory), a random access memory (RAM), a static random access memory (SRAM), a read-only memory (ROM), an electrically erasable programmable read-only memory (EEPROM), a programmable read-only memory (PROM), a magnetic memory, a magnetic disk, or an optical disk. The memory 470 may store an operating time of the aerosol generating device 400, a maximum number of puffs, a current number of puffs, at least one temperature profile (or heating profile), data associated with a smoking pattern of the user, or the like.

The communication unit 480 may include at least one component for communicating with another electronic device. For example, the communication unit 480 may include a short-range wireless communication unit 482 and a wireless communication unit 484.

The short-range wireless communication unit 482 may include, but is not limited to, a Bluetooth communication unit, a Bluetooth low energy (BLE) communication unit, a near field communication unit, a wireless local area network (WLAN) wireless fidelity (Wi-Fi) communication unit, a Zigbee communication unit, an infrared (IrDA, infrared Data Association) communication unit, a Wi-Fi Direct (WFD) communication unit, an ultra-wideband (UWB) communication unit, and an Ant+ communication unit, etc.

The wireless communication unit 484 may include, for example, a cellular network communication unit, an Internet communication unit, a computer network (e.g., a LAN or a wide-area network (WAN)) communication unit, or the like. However, embodiments are not limited thereto. The wireless communication unit 484 may use subscriber information (e.g., international mobile subscriber identity (IMSI)) to identify and authenticate the aerosol generating device 400 in a communication network.

The controller 410 may control the overall operation of the aerosol generating device 400. In an embodiment, the controller 410 may include at least one processor. The processor may be implemented as an array of a plurality of logic gates or may be implemented as a combination of a general-purpose microprocessor and a memory in which a program executable by the microprocessor is stored. In addition, it is to be understood by one of ordinary skill in the art to which the disclosure pertains that the processor may be implemented in other types of hardware.

The controller 410 may control the temperature of the heater 450 by controlling the supply of power from the battery 440 to the heater 450. For example, the controller 410 may control the supply of power by controlling the switching of a switching element between the battery 440 and the heater 450. In another example, a direct heating circuit may control the supply of power to the heater 450 according to a control command from the controller 410.

The controller 410 may analyze a sensing result obtained by the sensing of the sensing unit 420 and control processes to be performed thereafter. For example, the controller 410 may control power to be supplied to the heater 450 to start or end an operation of the heater 450 based on the sensing result obtained by the sensing unit 420. As another example, the controller 410 may control an amount of power to be supplied to the heater 450 and a time for which the power is to be supplied, such that the heater 450 may be heated up to a predetermined temperature or maintained at a desired temperature, based on the sensing result obtained by the sensing unit 420.

The controller 410 may control the output unit 430 based on the sensing result obtained by the sensing unit 420. For example, when a number of puffs counted through the puff sensor 426 reaches a preset number, the controller 410 may inform the user that the aerosol generating device 400 is to be ended soon, through at least one of the display 432, the haptic portion 434, and the sound outputter 436.

According to an embodiment, the controller 410 may control a power supply time and/or a power supply amount for the heater 450 according to a state of the aerosol generating article sensed by the sensing unit 420. For example, when the aerosol generating article is in an over-humidified state, the controller 410 may control the power supply time for an inductive coil to increase a preheating time, compared to a case where the aerosol generating article is in a general state.

An embodiment may also be implemented in the form of a recording medium including instructions executable by a computer, such as a program module executable by the computer. A computer-readable medium may be any available medium that may be accessed by a computer and includes all of a volatile medium, a non-volatile medium, a removable medium, and a non-removable medium. In addition, the computer-readable medium may include both a computer storage medium and a communication medium. The computer storage medium includes all of a volatile medium, a non-volatile medium, a removable medium, and a non-removable medium implemented by any method or technology for storage of information such as computer-readable instructions, data structures, program modules or other data. The communication medium typically includes computer-readable instructions, data structures, other data in modulated data signals such as program modules, or other transmission mechanisms, and includes any information transfer medium.

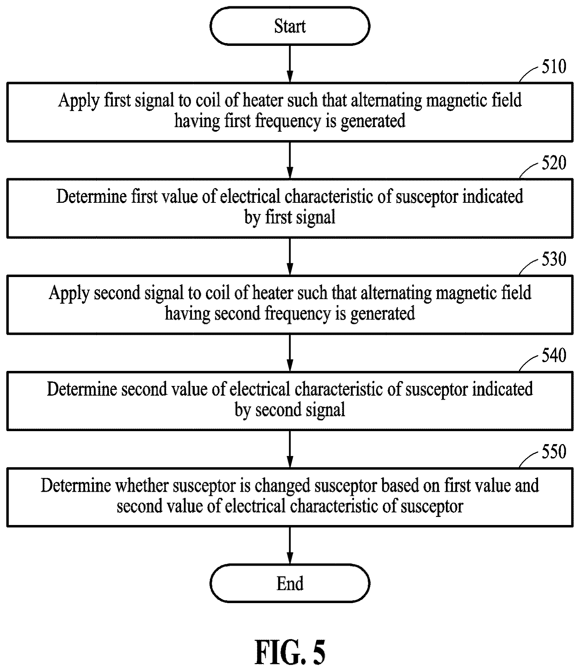

FIG. 5 is a flowchart of a method of determining whether a susceptor is a changed susceptor, according to various embodiments.

Operations 510 to 550 described below may be performed by an aerosol generating device (e.g., the aerosol generating device 1 of FIGS. 1a to 1d or the aerosol generating device 400 of FIG. 4). The aerosol generating device may include a heater (e.g., the heater 13 of FIGS. 1a to 1d or the heater 450 of FIG. 4) and a controller (e.g., the controller 12 of FIGS. 1a to 1d or the controller 410 of the aerosol generating device 400 of FIG. 4). For example, the heater may include a coil (e.g., the coil 13a of FIG. 1d) for induction heating.

In operation 510, the controller of the aerosol generating device may apply a first signal to the coil of the heater such that an alternating magnetic field having a first frequency is generated. The first signal may have a preset current, voltage, and duty ratio as a first test signal.

According to an embodiment, the aerosol generating device may include a DC/AC inverter and an amplifier for generating the first signal. For example, the amplifier may include a class D amplifier or a class E amplifier.

In an embodiment, the first frequency may be a frequency greater than a range of a natural frequencies (or matching frequencies) of a susceptor disposed within the aerosol generating device. For example, a plurality of susceptors may have different natural frequencies, but the different natural frequencies may be within a predetermined range. The natural frequency of a susceptor may be the frequency of a signal that may induce the largest eddy current in the susceptor. For example, when a range of natural frequencies is 230 KHz to 250 KHz, the first frequency may be 270 KHz.

In an embodiment, an operation of applying the first signal to the coil such that the temperature of the susceptor is not increased by an eddy current induced in the susceptor by the first signal may be performed for a short time (e.g., several milliseconds).

In an embodiment, the susceptor may not be electrically connected to the aerosol generating device.

In an embodiment, the susceptor may be disposed within the inside of an aerosol generating article when the aerosol generating article is inserted into the aerosol generating device. For example, the susceptor may be a tubular heating element, a plate-shaped heating element, a needle-shaped heating element, or a rod-shaped heating element.

According to an embodiment, the susceptor may be disposed to surround the outside of an aerosol generating article when the aerosol generating article is inserted into the aerosol generating device, such as the susceptor 13b of FIG. 1d.

In an embodiment, the susceptor may be included in an aerosol generating article that is inserted into the aerosol generating device. For example, the susceptor may be included in a filter wrapping paper of an aerosol generating article. For example, the susceptor may be included within a tobacco rod of an aerosol generating article.

In operation 520, the controller of the aerosol generating device may determine a first value of an electrical characteristic of the susceptor indicated by the first signal. For example, the electrical characteristic may be an eddy current occurring in the susceptor. For example, the electrical characteristic may be an impedance of the susceptor.

According to an embodiment, the aerosol generating device may further include a detection circuit for determining a value of an electrical characteristic of the susceptor indicated by the first signal. The detection circuit may not be electrically connected to the susceptor.

In operation 530, the controller of the aerosol generating device may apply a second signal to the coil of the heater such that an alternating magnetic field having a second frequency is generated. The second signal may have a preset current, voltage, and duty ratio as a second test signal.

In an embodiment, the second frequency may be a frequency greater than a range of natural frequencies of a susceptor disposed within the aerosol generating device. For example, when a range of natural frequencies is 230 KHz to 250 KHz, the second frequency may be 280 KHz.

In an embodiment, an operation of applying the second signal to the coil such that the temperature of the susceptor is not increased by an eddy current induced in the susceptor by the second signal may be performed for a short time (e.g., several milliseconds).

In operation 540, the controller of the aerosol generating device may determine a second value of an electrical characteristic of the susceptor indicated by the second signal. For example, the electrical characteristic may be an eddy current occurring in the susceptor. For example, the electrical characteristic may be an impedance of the susceptor.

In operation 550, the controller of the aerosol generating device may determine whether the susceptor is a changed susceptor based on the first value and the second value of the electrical characteristic of the susceptor. For example, when at least one of the first value and the second value is different from a previous first value and a previous second value measured for a previous susceptor, the controller of the aerosol generating device may determine that the susceptor is a changed susceptor. For example, when the first value and the second value are equal to a previous first value and a previous second value measured for a previous susceptor, the controller of the aerosol generating device may determine that the susceptor is an unchanged susceptor.

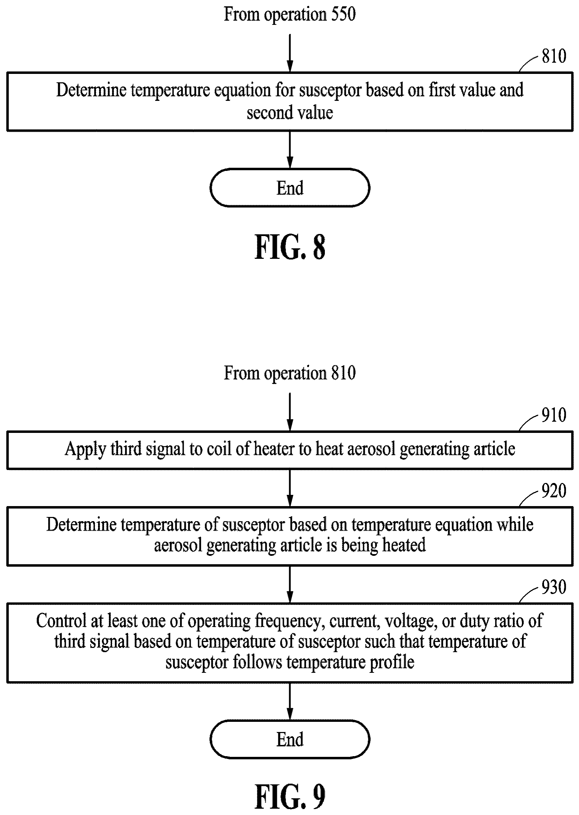

In an embodiment, when it is determined that the susceptor has changed, the controller of the aerosol generating device may determine a temperature equation for the susceptor. The temperature equation may be used to determine a temperature of the susceptor while the aerosol generating article inserted into the aerosol generating device is being heated. A method of determining the temperature equation for the susceptor is described in detail below with reference to FIG. 8.

In an embodiment, when it is determined that the susceptor is not changed, the controller of the aerosol generating device may maintain a predetermined temperature equation for the susceptor.

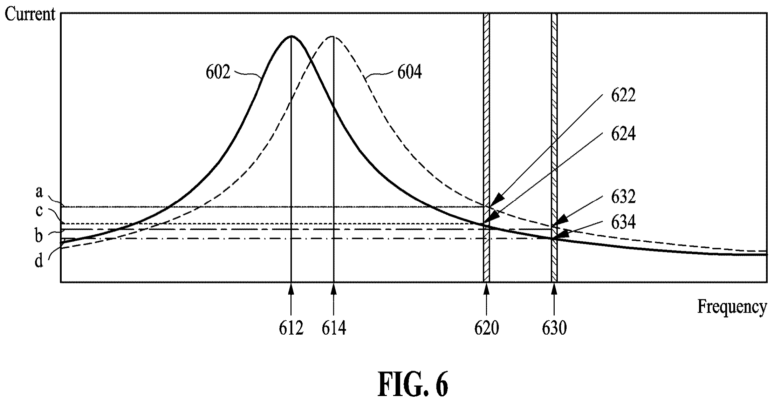

FIG. 6 is a diagram illustrating trajectories of eddy currents in a susceptor indicated by frequencies of signals, according to various embodiments.

In an embodiment, a first susceptor and a second susceptor may exhibit different electrical characteristics for the same signal. For example, since a first natural frequency 612 of the first susceptor and a second natural frequency 614 of the second susceptor are different from each other, a first eddy current trajectory 602 of the first susceptor and a second eddy current trajectory 604 of the second susceptor, which are indicated by the frequency of a given signal, may be different. For example, even when the same manufacturing process and the same materials are used, the first natural frequency 612 of the first susceptor and the second natural frequency 614 of the second susceptor may be different from each other due to tolerances occurring during the manufacturing process of the susceptors. For example, each of the susceptors may be manufactured to have different electrical characteristics.

When an aerosol generating device (e.g., the aerosol generating device 1 of FIGS. 1a to 1d or the aerosol generating device 400 of FIG. 4) may perform a frequency sweep over the entire frequency band, the first eddy current trajectory 602 of the first susceptor and the second eddy current trajectory 604 of the second susceptor may be generated. The aerosol generating device may determine that the first susceptor and the second susceptor are not the same when the first eddy current trajectory 602 of the first susceptor and the second eddy current trajectory 604 of the second susceptor are not the same. However, for an aerosol generating device to perform a frequency sweep over the entire frequency band, a large amount of computation and a lot of processing time may be required.

According to an embodiment, the aerosol generating device may determine a first value c and a second value d of an eddy current appearing in the first susceptor by using a first signal having a first frequency 620 and a second signal having a second frequency 630, to reduce the amount of computation and processing time required. The aerosol generating device may store in advance a first value a and a second value b of an eddy current appearing in the second susceptor by using the first signal having the first frequency 620 and the second signal having the second frequency 630. For example, the first susceptor may be the replaced susceptor, and the second susceptor may be the susceptor before being replaced.

The aerosol generating device may determine whether the first value c and the second value d for the first susceptor and the first value a and the second value b for the second susceptor are the same, respectively. For example, the aerosol generating device may determine that the first susceptor and the second susceptor are the same susceptor when the first value c and the second value d for the first susceptor and the first value a and the second value b for the second susceptor are the same, respectively. For example, the aerosol generating device may determine that the first susceptor and the second susceptor are not the same susceptors when at least one of the first value c and the second value d for the first susceptor is not equal to the first value a and the second value b for the second susceptor.

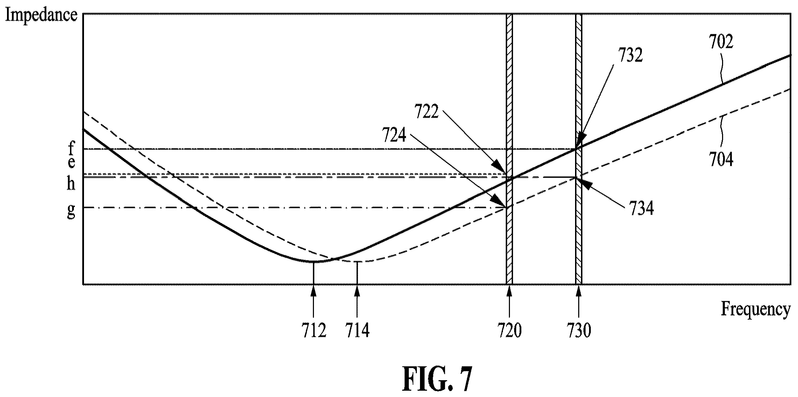

FIG. 7 is a diagram illustrating trajectories of impedance in a susceptor indicated by frequencies of signals, according to various embodiments.

In an embodiment, a first susceptor and a second susceptor may exhibit different electrical characteristics for the same signal. For example, since a first natural frequency 712 of the first susceptor and a second natural frequency 714 of the second susceptor are different from each other, a first impedance trajectory 702 of the first susceptor and a second impedance trajectory 704 of the second susceptor, which are indicated by the frequency of a given signal, may be different.

When an aerosol generating device (e.g., the aerosol generating device 1 of FIGS. 1a to 1d or the aerosol generating device 400 of FIG. 4) may perform a frequency sweep over the entire frequency band, the first impedance trajectory 702 of the first susceptor and the second impedance trajectory 704 of the second susceptor may be generated. The aerosol generating device may determine that the first susceptor and the second susceptor are not the same when the first impedance trajectory 702 of the first susceptor and the second impedance trajectory 704 of the second susceptor are not the same. However, for an aerosol generating device to perform a frequency sweep over the entire frequency band, a large amount of computation and a lot of processing time may be required.

According to an embodiment, the aerosol generating device may determine a first value e and a second value f of an impedance appearing in the first susceptor by using a first signal having a first frequency 720 and a second signal having a second frequency 730, to reduce the amount of computation and processing time required. The aerosol generating device may store in advance a first value g and a second value h of an impedance appearing in the second susceptor by using the first signal having the first frequency 720 and the second signal having the second frequency 730. For example, the first susceptor may be the replaced susceptor, and the second susceptor may be the susceptor before being replaced.

The aerosol generating device may determine whether the first value e and the second value f for the first susceptor and the first value g and the second value h for the second susceptor are the same, respectively. For example, the aerosol generating device may determine that the first susceptor and the second susceptor are the same susceptor when the first value e and the second value f for the first susceptor and the first value g and the second value h for the second susceptor are the same, respectively. For example, the aerosol generating device may determine that the first susceptor and the second susceptor are not the same susceptors when at least one of the first value e and the second value f for the first susceptor is not equal to the first value g and the second value h for the second susceptor.

FIG. 8 is a flowchart of a method of determining a temperature equation for a susceptor based on a first value and a second value of an electrical characteristic of the susceptor, according to various embodiments.

According to an embodiment, operation 810 described below may be further performed after operation 550 described above with reference to FIG. 5 is performed. For example, when it is determined that the susceptor is a changed susceptor, operation 810 may be performed. Operation 810 may be performed by an aerosol generating device (e.g., the aerosol generating device 1 of FIGS. 1a to 1d or the aerosol generating device 400 of FIG. 4).

In operation 810, a controller of the aerosol generating device may determine a temperature equation for the susceptor based on the first value and the second value of an electrical characteristic of the susceptor. For example, the temperature equation may be in the form of a first-order equation to reduce the amount of calculation, but is not limited to the described embodiment, and may be in the form of a second-order or higher-order equation.

In an embodiment, the first-order equation may be of the form y = ax + b. For example, in the first-order equation, x may be a value of a frequency of a signal provided to the susceptor, and y may be a value of an eddy current appearing in the susceptor. For example, in the first-order equation, x may be a value of a frequency of a signal provided to the susceptor, and y may be a value of an impedance of the susceptor. The values of a and b of the first-order equation may be determined based on the first value and the second value of the electrical characteristics of the susceptor. When a first frequency of a first signal and a second frequency of a second signal are greater than a natural frequency of the susceptor, the value of a in the temperature equation for the eddy current of the susceptor may be negative, or the value of a in the temperature equation for the impedance of the susceptor may be positive.

FIG. 9 is a flowchart of a method of controlling a temperature of a susceptor while an aerosol generating article is being heated, according to various embodiments.

According to an embodiment, operations 910 to 930 may be performed after operation 810 described above with reference to FIG. 8 is performed. For example, when a function for heating an aerosol generating article is activated, operations 910 to 930 may be performed.

Operations 910 to 930 may be performed by an aerosol generating device (e.g., the aerosol generating device 1 of FIGS. 1a to 1d or the aerosol generating device 400 of FIG. 4).

In operation 910, a controller of the aerosol generating device may apply a third signal to a coil of a heater to heat the aerosol generating article. The third signal may be a signal having a third frequency. The third signal may be a signal having a frequency greater than a natural frequency of the susceptor. The coil may generate an alternating magnetic field having the third frequency based on the third signal. The alternating magnetic field may induce an eddy current in the susceptor. Heat may be generated in the susceptor by the generated eddy current.

In operation 920, the controller of the aerosol generating device may determine a temperature of the susceptor based on a temperature equation while the aerosol generating article is being heated. For example, the aerosol generating device may determine a third value of an electrical characteristic of the susceptor via a detection circuit.

In an embodiment, the aerosol generating device may determine the temperature of the susceptor, based on a third value of an eddy current indicated by the third signal having the third frequency and the temperature equation.

In an embodiment, as the temperature of the susceptor increases, an inductance and/or resistance of the susceptor may increase. As the inductance of the susceptor increases, the natural frequency of the susceptor at that temperature (e.g., a second temperature) may decrease. When the natural frequency of the susceptor is lowered, the eddy current trajectories appearing at room temperature (e.g., a first temperature) may have an effect of being shifted to the left with respect to the frequency axis. Accordingly, the third value of the eddy current indicated by the signal of the third frequency at the corresponding temperature (e.g., the second temperature) may be reduced compared to the value of the eddy current indicated by the signal of the third frequency at room temperature (e.g., the first temperature). The aerosol generating device may set the third value of the eddy current to be a y value of the temperature equation, and determine a reference frequency to be an x value accordingly. The aerosol generating device may determine the temperature of the susceptor based on a difference between the reference frequency and the third frequency. For example, a change in the shift of the natural frequency of the susceptor due to a change in temperature may be calculated in advance. For example, the change (e.g., tens or hundreds of degrees Celsius) in temperature of the susceptor may be proportionally calculated for the change (e.g., tens of KHz) in natural frequency of the susceptor. For example, the change (e.g., tens or hundreds of degrees Celsius) in temperature of the susceptor may be proportionally calculated for the rate of change in the natural frequency of the susceptor.

In an embodiment, as the temperature of the susceptor increases, an inductance and/or resistance of the susceptor may increase. As the inductance of the susceptor increases, the natural frequency of the susceptor at that temperature (e.g., a second temperature) may decrease. When the natural frequency of the susceptor is lowered, impedance trajectories appearing at room temperature (e.g., the first temperature) may have an effect of being shifted to the left with respect to the frequency axis. Accordingly, the third value of the impedance indicated by the signal of the third frequency at the corresponding temperature (e.g., the second temperature) may be increased compared to the value of the impedance indicated by the signal of the third frequency at room temperature (e.g., the first temperature). The aerosol generating device may set the third value of the impedance to be a y value of the temperature equation, and determine a reference impedance to be an x value accordingly. The aerosol generating device may determine the temperature of the susceptor based on a difference between the reference impedance and the third frequency. For example, a change in the shift of the natural frequency of the susceptor due to a change in temperature may be calculated in advance. For example, the change (e.g., tens or hundreds of degrees Celsius) in temperature of the susceptor may be proportionally calculated for the change (e.g., tens of KHz) in natural frequency of the susceptor. For example, the change (e.g., tens or hundreds of degrees Celsius) in temperature of the susceptor may be proportionally calculated for the rate of change in the natural frequency of the susceptor.

In operation 930, the controller of the aerosol generating device may control at least one of an operating frequency, current, voltage, or duty ratio of the third signal based on the temperature of the susceptor such that the temperature of the susceptor follows a temperature profile. For example, when the temperature of the susceptor is greater than a temperature of the temperature profile, the operating frequency of the third signal may be increased, the current may be decreased, the voltage may be decreased, or the duty ratio may be decreased. For example, when the temperature of the susceptor is less than a temperature of the temperature profile, the operating frequency of the third signal may be reduced toward the natural frequency, the current may be increased, the voltage may be increased, or the duty ratio may be increased.

The methods according to the above-described embodiments may be recorded in non-transitory computer-readable media including program instructions to implement various operations of the above-described embodiments. The media may also include, alone or in combination with the program instructions, data files, data structures, and the like. The program instructions recorded on the media may be those specially designed and constructed for the purposes of embodiments, or they may be of the kind well-known and available to one of ordinary skill in the computer software arts. Examples of non-transitory computer-readable media include magnetic media such as hard disks, floppy disks, and magnetic tape; optical media such as CD-ROM discs or DVDs; magneto-optical media such as optical discs; and hardware devices that are specially configured to store and perform program instructions, such as read-only memory (ROM), RAM, flash memory, and the like. Examples of program instructions include both machine code, such as produced by a compiler, and files containing higher-level code that may be executed by the computer using an interpreter. The above-described devices may be configured to act as one or more software modules in order to perform the operations of the above-described examples, or vice versa.

The software may include a computer program, a piece of code, an instruction, or some combination thereof, to independently or collectively instruct or configure the processing device to operate as desired. Software and/or data may be embodied permanently or temporarily in any type of machine, component, physical or virtual equipment, computer storage medium or device, or in a propagated signal wave capable of providing instructions or data to or being interpreted by the processing device. The software may also be distributed over network-coupled computer systems so that the software is stored and executed in a distributed fashion. The software and data may be stored by one or more non-transitory computer-readable recording mediums.

While the embodiments are described with reference to drawings, it will be apparent to one of ordinary skill in the art that various alterations and modifications in form and details may be made in these embodiments without departing from the scope of the claims and their equivalents. For example, suitable results may be achieved if the described techniques are performed in a different order, and/or if components in a described system, architecture, device, or circuit are combined in a different manner, and/or rearranged or supplemented by other components or their equivalents.

Therefore, other implementations, other embodiments, and equivalents to the claims are also within the scope of the following claims.

## Claims

1. A method of determining a susceptor change performed by an aerosol generating device, the method comprising:
applying a first signal to a coil of a heater such that an alternating magnetic field having a first frequency is generated;
determining a first value of an electrical characteristic of a susceptor indicated by the first signal;
applying a second signal to the coil of the heater such that an alternating magnetic field having a second frequency is generated;
determining a second value of an electrical characteristic of the susceptor indicated by the second signal; and
determining whether the susceptor is a changed susceptor based on the first value and the second value.

2. The method of claim 1, wherein the susceptor is disposed inside an aerosol generating article when the aerosol generating article is inserted into the aerosol generating device.

3. The method of claim 1, wherein the susceptor is disposed to surround an outside of the aerosol generating article when the aerosol generating article is inserted into the aerosol generating device.

4. The method of claim 1, wherein the susceptor is comprised in an aerosol generating article inserted into the aerosol generating device.

5. The method of claim 1, wherein the electrical characteristic of the susceptor is an eddy current.

6. The method of claim 1, wherein the electrical characteristic of the susceptor is impedance.

7. The method of claim 1, wherein the first frequency and the second frequency are frequencies greater than a natural frequency of the susceptor.

8. The method of claim 1, further comprising:
determining a temperature equation for the susceptor based on the first value and the second value,
wherein the temperature equation is used to determine a temperature of the susceptor while the aerosol generating article inserted into the aerosol generating device is being heated.

9. The method of claim 8, further comprising:
applying a third signal to the coil of the heater to heat the aerosol generating article;
determining the temperature of the susceptor based on the temperature equation while the aerosol generating article is being heated; and
controlling at least one of an operating frequency, a current, a voltage, or a duty ratio of the third signal such that the temperature of the susceptor follows a temperature profile based on the temperature of the susceptor.

10. A non-transitory computer-readable storage medium storing a program for executing the method of claim 1.

11. An aerosol generating device, comprising:
a coil configured to generate an alternating magnetic field; and
a controller controlling the aerosol generating device, wherein the controller is configured to:
apply a first signal to the coil such that an alternating magnetic field having a first frequency is generated;
determine a first value of an electrical characteristic of a susceptor indicated by the first signal;
apply a second signal to the coil such that an alternating magnetic field having a second frequency is generated;
determine a second value of an electrical characteristic of the susceptor indicated by the second signal; and
determine whether the susceptor is a changed susceptor based on the first value and the second value.

12. The aerosol generating device of claim 11, wherein the susceptor is disposed inside an aerosol generating article when the aerosol generating article is inserted into the aerosol generating device.

13. The aerosol generating device of claim 11, further comprising the susceptor, wherein the susceptor is disposed inside an aerosol generating article when the aerosol generating article is inserted into the aerosol generating device.

14. The aerosol generating device of claim 11, further comprising: the susceptor, wherein the susceptor is disposed to surround an outside of the aerosol generating article when the aerosol generating article is inserted into the aerosol generating device.
